# EUROPÄISCHE PATENTANMELDUNG

(11) **EP 2 466 640 A2**
(43) Veröffentlichungstag der Anmeldung: **20.06.2012**
(21) Anmeldenummer: 11194107.6
(22) Anmeldetag: 16.12.2011
(51) Int. Cl.: H01L 27/142

(54) **Dünnschicht-Photovoltaikmodul**

(30) Priorität: 16.12.2010 DE 202010013136 U
(71) Anmelder: Malibu GmbH & Co. Kg, 33609 Bielefeld (DE)
(72) Erfinder: Gruss, Stefan, 32130 Enger (DE); Hamelmann, Frank Uwe, 32049 Herford (DE); Westerwalbesloh, Thomas, 33334 Gütersloh (DE); Petri, Stefan, 33659 Bielefeld (DE); Stiebig, Helmut, 33415 Verl (DE)
(74) Vertreter: Kleine, Hubertus

(57) **Zusammenfassung**

Die Erfindung betrifft ein Dünnschicht-Photovoltaikmodul, das durch Trennlinien (21-23, 30), die mindestens eine Schicht eines Schichtaufbaus des Dünnschicht-Photovoltaikmoduls durchtrennen, in eine Vielzahl von auf einem Substrat (11) angeordneten und integriert elektrisch serienverschalteten Photovoltaikzellen (10) unterteilt ist, wobei zumindest zwei der Trennlinien (21-23, 30) nicht parallel zueinander verlaufen, zumindest ein Teil der Trennlinien (21-23) Teil eines Serienverschaltungsstreifens (20) ist, der zwei angrenzende Photovoltaikzellen (10) serienverschaltet, und mindestens eine der Trennlinien (30) alle Schichten des Dünnschicht-Photovoltaikmoduls durchtrennt und zwei angrenzende Photovoltaikzellen (10) gegeneinander elektrisch isoliert. Das Dünnschicht-Photovoltaikmodul zeichnet sich dadurch aus, dass Serienverschaltungsstreifen (20) und isolierende Trennlinien (30) so angeordnet sind, dass ein Strompfad (40) gebildet wird, der mäanderförmig über das Dünnschicht-Photovoltaikmodul verläuft.

## Beschreibung

Die Erfindung betrifft ein Dünnschicht-Photovoltaikmodul, das durch Trennlinien, die mindestens eine Schicht eines Schichtaufbaus des Dünnschicht-Photovoltaikmoduls durchtrennen, in eine Vielzahl von auf einem Substrat angeordneten und integriert elektrisch serienverschalteten Dünnschicht-Photovoltaikzellen unterteilt ist. Zumindest zwei der Trennlinien verlaufen dabei nicht parallel zueinander, wobei die Trennlinien teilweise Serienverschaltungsstreifen bilden, die zwei angrenzende Photovoltaikzellen serienverschalten und teilweise Trennlinien bilden, die alle Schichten des Dünnschicht-Photovoltaikmoduls durchtrennen und zwei angrenzende Photovoltaikzellen gegeneinander elektrisch isolieren.

Dünnschicht-Photovoltaikmodule, auch Dünnschicht-Solarmodule genannt, weisen einen Schichtaufbau mit Schichten von Dicken im Bereich von Nanobis Mikrometern auf. Der Schichtaufbau umfasst üblicherweise Elektrodenschichten, zum Beispiel aus einem elektrisch leitenden transparenten Material, meist einem transparenten leitenden Metalloxid (TCO - Transparent Conductive Oxide), eine oder mehrerer photovoltaisch aktive Schichtanordnungen und eine metallische und/oder nichtmetallische Rückkontaktschicht. Eine photovoltaisch aktive Schichtanordnung umfasst dabei mindestens zwei und üblicherweise drei photovoltaisch aktive Schichten, zum Beispiel aus einem amorphen und/oder mikrokristallinen Halbleitermaterial, von denen eine positiv, eine andere negativ dotiert ist (PN-Übergang) und die optionale dritte Schicht intrinsisch ist (PIN-Übergang). Es können vertikal übereinander mehrere photovoltaisch aktive Schichtanordnungen vorgesehen sein, zum Beispiel bei den sogenannten Tandem- oder Tripelzellen-Modulen. Auch eine Kombination von amorphen und mikrokristallinen Halbleitermaterialien innerhalb einer oder untarschiedlicher photovoltaisch aktiver Schichtanordnungen ist möglich. Als photovoltaisch aktive Halbleitermaterialien kommen Si oder Ge in Frage oder auch Verbindungshalbleiter wie CdTe oder Cu(In, Ga)Se₂. Letzteres wird abgekürzt auch als CIS oder CIGS bezeichnet.

Dünnschicht-Photovoltaikmodule können unter Verwendung verschiedener Abscheideverfahren, zum Beispiel PVD (Physical Vapour Deposition) oder CVD (Chemical Vapour Deposition)-Verfahren vorteilhaft graßflächig hergestellt werden. Sie finden daher zunehmend Einsatz in Freiflächen-Photovoltaikanlagen und im Architekturbereich, z.B. als in Gebäude, beispielsweise in Fassaden, integrierte Photovoltaikmodule.

Aufgrund einer beschränkten lateralen elektrischen Leitfähigkeit der Elektrodenschichten sowie zur Anpassung der Ausgangsspannungen und - ströme von Dünnschicht-Photovoltaikmodulen erfolgt üblicherweise eine Unterteilung des Moduls in eine Vielzahl von nebeneinander angeordneten streifenförmigen Einzelzellen, die untereinander elektrisch serienverschaltet sind. Die Breite der streifenförmigen Einzelzellen liegt dabei üblicherweise im Bereich von etwa einigen Millimetern bis Zentimetern.

Ein Verfahren zur Unterteilung eines Dünnschicht-Photovoltaikmoduls in einzelnen Zellen und zur Serienverschaltung dieser Einzelzellen ist beispielsweise aus der Patentschrift DE 37 14 920 C1 bekannt. Während des Aufbringens des Schichtaufbaus des Dünnschicht-Photovoltaikmoduls werden einzelne Schichten oder Schichtanordnungen des Schichtaufbaus durch Trennlinien in eine Vielzahl von streifenförmigen Segmenten unterteilt. In der vertikalen Abfolge des Schichtaufbaus werden solche Trennlinien leicht seitlich versetzt in unterschiedliche Schichten (Elektrodenschicht, photovoltaisch aktive Schichtanordnung, Rückkontaktschicht) eingebracht. Die Trennlinien werden durch das Material nachfolgend aufgebrachter Schichten verfüllt, wodurch eine Kontaktierung von Schichten in vertikaler Richtung des Schichtaufbaus erreicht wird. Bei geeigneter Anordnung der Trennlinien wird das Dünnschicht-Photovoltaikmodul auf diese Weise in eine Vielzahl von nebeneinanderliegenden streifenförmigen einzelnen Photovoltaikzellen unterteilt, die elektrisch in Reihe geschaltet sind. Bei den im Allgemeinen rechteckig ausgeführten Dünnschicht-Photovoltaikmodulen weisen alle Zellen die gleiche Breite auf, damit in jeder einzelnen Zelle die gleiche Flächenstromdichte vorliegt. Anderenfalls würde die Zelle mit der kleinsten Fläche den Maximalstrom des gesamten Moduls bestimmen und es wäre nicht möglich, alle Zellen gleichzeitig an ihrem günstigsten Strom/Spannungs-Arbeitspunkt zu betreiben.

Insbesondere beim Anwendungsbereich der Integration von Dünnschicht-Photovoltaikmodulen in Gebäude ergibt sich der Wunsch, Dünnschicht-Photovoltaikmodule auch in anderen als rechteckigen Grundformen zur Verfügung zu haben. Beispielsweise sind zur Integration in Giebel oder Dachgauben dreieckige Grundformen bevorzugt. Die bekannten Techniken zur Strukturierung von Dünnschicht-Photovoltaikmodulen in serienverschaltete streifenförmige Einzelzellen lassen sich hier nur bedingt einsetzen.

Um der oben angegebenen Forderung nach einer Konstanz der Flächen der Einzelzellen über das gesamte Photovoltaikmodul nachzukommen, ist beispielsweise aus der Druckschrift WO 2008/042682 A2 bekannt, bei einer Unterteilung des Moduls in streifenförmige Einzelzellen die Breite der Streifen zur Spitze eines dreieckigen Moduls hin zu verbreitern. Mit zunehmender Streifenbreite steigen jedoch die Widerstandsverluste bei der lateralen Ableitung des Stroms durch die dünnen Elektroden und/oder Rückkontaktschichten. Um dennoch ein großflächiges Modul herstellen zu können, ist in dieser Druckschrift zudem beschrieben, ein großflächiges Substrat in mehrere kleinere Bereiche zu unterteilen, von denen jeder integriert serienverschaltete streifenförmige Einzelzellen mit zur Spitze hin zunehmender Breite aufweist. Die einzelnen Bereiche sind dann konventionell mit einzelnen Zuleitungen untereinander verschaltet. Letzteres führt zu einem arbeitsaufwändigen Herstellungsprozess, insbesondere da sich die konventionelle Verdrahtung nur schlecht automatisieren lässt.

Aus der Druckschrift JP 10 07 49 64 A ist es bekannt, ein Photovoltaikmodul mit einer dreieckigen Grundform in serienverschaltete dreieckige Zellen zu unterteilen, wobei die einzelnen Zellen fächerförmig auf dem Modul angeordnet sind. Die Trennlinien, mit denen eine Serienverschaltung erfolgt, laufen hierbei im Unterschied zu vorgenannter Druckschrift WO 2008/042682 A2 nicht parallel zueinander, sondern gehen strahlenförmig von einer Spitze des dreieckigen Moduls aus. Die Winkel zwischen zwei benachbarten Serienverschaltungsstreifen zwischen den Zellen variieren derart, dass die Einzelzellen jeweils gleiche Flächen aufweisen. An der der Spitze, von welcher die Serienverschaltungsstreifen des Streifens ausgehen, gegenüberliegenden Seite des Photovoltaikmoduls steigen mit zunehmender Größe des Moduls auch bei dieser Ausführung die Streifenbreite und damit die Widerstandsverluste an.

Eine weitere Vorgehensweise, um nicht rechteckige Photovoltaikmodule integriert serienverschalten zu können, ist in der Druckschrift EP 1 855 325 A1 beschrieben. Hierbei wird das Photovoltaikmodul in eine Vielzahl kleinerer Zellen unterteilt, die auf dem Photovoltaikmodul kachelähnlich angeordnet sind. Jeweils in einer Richtung hintereinander liegende Einzelzellen werden miteinander serienverschaltet. Es werden auf diese Weise mehrere parallel zueinander angeordnete Ketten von einzelnen, innerhalb der Ketten serienverschaltete Zellen gebildet. Die Ketten werden über eine extern verlaufende, konventionelle Verdrahtung so miteinander verbunden, dass Ketten gleicher Länge gebildet werden, die dann elektrisch parallel zueinander geschaltet werden. Auch hierbei führt die konventionelle Verdrahtung wiederum zu einem arbeitsaufwändigem Herstellungsprozess.

Es ist daher eine Aufgabe der Erfindung, ein Dünnschicht-Photovoltaikmodul zu schaffen, das auch bei nichtrechteckiger Grundform des Moduls effektiv und insbesondere mit minimalen Widerstandsverlusten arbeitet und effizient herstellbar ist.

Diese Aufgabe wird durch ein Dünnschicht-Photovoltaikmodul mit den Merkmalen des unabhängigen Anspruchs gelöst.

Ein erfindungsgemäßes Dünnschicht-Photavoltaikmodul der eingangs genannten Art zeichnet sich dadurch aus, dass Sorienverschaltungsstreifen und isolierende Trennlinien so angeordnet sind, dass ein Strompfad gebildet wird, der mäanderförmig über das Dünnschicht-Photovoltaikmodul verläuft.

Durch die Kombination von Serienverschaltungsstreifen und isolierende Trennlinien wird durch den mäanderförmigen Verlauf des Strompfads eine Serienverschaltung der Photovoltaikzellen möglich, ohne dass extern verlaufende Verbindungen benötigt werden. Die Photovoltaikzellen des Photovoltaikmoduls können integriert miteinander verschaltet werden, was eine unaufwändige Herstellung erlaubt. Zudem kann eine Unterteilung auch eines nicht rechteckigen Photovoltaikmoduls in serienverschaltete Photovoltaikzellen erfolgen, ohne dass die Photovoltaikzellen an einer Seitenkante oder Spitze des Photovoltaikmoduls in ihren Ausdehnungen derart zunehmen, dass untragbare Widerstandsverluste die Folge wären.

In einer vorteilhaften Ausgestaltung des Dünnschicht-Photovoltaikmoduls ist dieses von den Trennlinien in flächengleiche Photovoltaikzellen unterteilt, was zu einer möglichst effektiven Nutzung der photovoltaisch aktiven Fläche des Photovoltaikmoduls führt.

In einer weiteren vorteilhaften Ausgestaltung des Dünnschicht-Photovoltaikmoduls weist zumindest ein Teil der Photovoltaikzellen eine dreieckige, trapezförmige oder hexagonale Grundform auf. Bevorzugt hat zumindest ein Teil der Photovoltaikzellen und besonders bevorzugt haben alle Photovoltaikzellen die gleiche geometrische Grundform wie das Dünnschicht-Photovoltaikmodul. Auf diese Weise kann eine effektiv flächendeckende Unterteilung des Photovoltaikmoduls erfolgen.

In einer weiteren vorteilhaften Ausgestaltung des Dünnschicht-Photovoltaikmoduls ist ein Strompfad von einer ersten Photovoltaikzelle bis zu einer letzten Photovoltaikzelle gebildet, entlang dem alle Photovoltaikzellen miteinander serienverschaltet sind. Auf diese Weise ist das Photovoltaikmodul gut kontaktierbar.

Weitere vorteilhafte Ausgestaltungen und Weiterbildungen sind in den abhängigen Ansprüchen angegeben

Im Folgenden wird die Erfindung anhand von Ausführungsbeispielen mit Hilfe von sieben Figuren näher erläutert.

Die Figuren zeigen:
- Figur 1: ein Dünnschicht-Photovoltaikmodul in einer Aufsicht in einem ersten Ausführungsbeispiel;
- Figur 2: ein Querschnitt durch das Dünnschicht-Photovoltaikmodul der Figur 1 im Bereich eines Serienverschaltungsstreifens;
- Figur 3: ein Querschnitt durch das Dünnschicht-Photovoltaikmodul der Figur 1 im Bereich einer Isolier-Trennlinie und
- Figuren 4 - 7: jeweils eine Aufsicht auf ein Dünnschicht-Photovoltaikmodul in weiteren Ausführungsbeispielen.

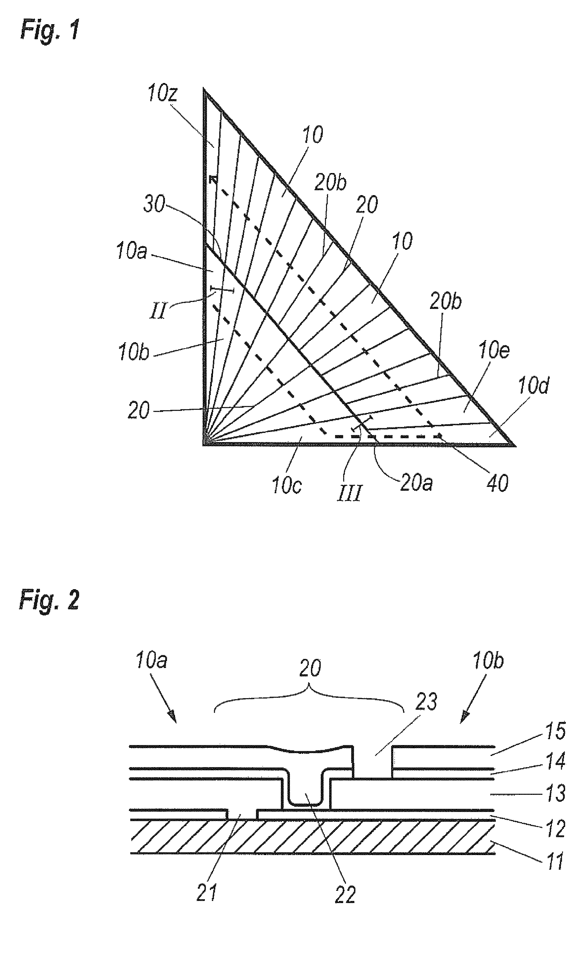

Figur 1 zeigt ein Dünnschicht-Photovoltaikmodul in einer schematischen Darstellung in der Aufsicht. Alle Ausführungen dieser Anmeldung beziehen sich auf Photovoltaikmodule in Dünnschicht-Technologie. Zur einfacheren Darstellung entfällt daher im Folgenden die Spezifizierung "Dünnschicht" und der Begriff "Photovoltaik" wird durch die Abkürzung PV ersetzt. Das Dünnschicht-Photovoltaikmodul wird dem zu Folge in diesem und auch den weiteren Ausführungsbeispielen als PV-Modul bezeichnet.

Das PV-Modul ist eben und flächig ausgeführt und weist in diesem Ausführungsbeispiel bezüglich seiner lateralen Ausdehnung eine rechtwinkligdreieckige geometrische Grundform auf.

Das PV-Modul ist in eine Vielzahl von Photovoltaikzellen 10, im Folgenden PV-Zellen 10 genannt, unterteilt. Für eine spätere Bezugnahme sind einige der PV-Zellen 10 mit alphabetischen Indizes a, b usw. versehen. Zwischen benachbarten PV-Zellen 10 verlaufen Serienverschaltungsstreifen 20 bzw. eine Isolier-Trennlinie 30 getrennt. Aus Gründen der Übersichtlichkeit sind in der Figur 1 nicht alle der PV-Zellen 10 und Serienverschaltungsstreifen 20 mit Bezugszeichen versehen.

Von der rechtwinkligen Ecke des PV-Moduls verlaufen fächerförmig Serienverschaltungsstreifen 20 zur gegenüberliegenden Seite des PV-Moduls. Diese Serienverbindungsstreifen teilen das PV-Modul zunächst in acht dreieckige Segmente. Parallel zu der dem rechten Winkel gegenüberliegenden Seite des PV-Moduls ist in etwa mittig eine Isolier-Trennlinie 30 vorgesehen. In der Figur ist diese Isolier-Trennlinie 30 durch eine breiteren Linie dargestellt als die Serienverschaltungsstreifen 20. Die Isolier-Trennlinie 30 durchtrennt die im Uhrzeigersinn ersten sieben dreieckigen Segmente vollständig und das achte zu Hälfte. Durch die zweite Hälfte des achten Segmentes führt ein in Verlängerung der Isolier-Trennlinie 30 verlaufender kurzer Serienverschaltungsstreifen, der in der Figur 1 mit dem Bezugszeichen 20a versehen ist.

Die Isoliertrennlinie 30 bzw. der Serienverschaltungsstreifen 20a trennen von den acht dreieckigen Segmenten auf der von dem rechten Winkel des Moduls abgewandten Seite unterschiedlich geformte viereckige Segmente ab. Diese viereckigen Segmente sind von weiteren Serienveschaltungsstreifen, die in der Figur 1 mit dem Bezugszeichen 20b versehen sind, der Länge nach in zwei Abschnitte unterteilt.

Die Unterteilung des PV-Moduls durch die Serienverschaltungsstreifen 20, 20a, 20b und die Isolier-Trennlinie 30 resultiert in diesem Ausführungsbeispiel in 24 einzelnen PV-Zellen 10. Von diesen sind in der Figur einige zur Referenzierung mit Indizes a bis e und z versehen.

Beispielhaft ist zwischen der PV-Zelle 10a und der PV-Zelle 10b eine Schnittlinie II eingezeichnet. Entlang dieser Schnittlinie II weist das PV-Modul einen Querschnitt auf, der in der Figur 2 detaillierter dargestellt ist.

Wie Figur 2 zeigt, umfasst das PV-Modul ein Substrat 11, beispielsweise ein Glassubstrat, auf das eine frontseitige Elektrodenschicht 12, beispielsweise aus einem TCO-Material, aufgebracht ist. Auf dieser befindet sich eine photovoltaisch (PV-) aktive Schichtanordnung 13, beispielsweise ein PIN-Übergang. Auf der PV-aktiven Schichtanordnung 13 sind eine rückseitige Elektrodenschicht 14 sowie eine Rückkontaktschicht 15 aufgebracht. Die rückseitige Elektrodenschicht 14 kann beispielsweise ebenfalls aus einem TCO-Material erstellt sein. Die Rückkontaktschicht 15 ist bevorzugt eine aufgedampfte Metallschicht, beispielsweise aus Aluminium oder Silber oder einer Legierung, die zumindest eines dieser Materialien aufweist. Auch eine Kombination aus einer TCO-Schicht und einer reflektierenden Schicht kann als Rückkontaktschicht 15 eingesetzt werden.

Der dargestellte Schichtaufbau des PV-Moduls ist lediglich beispielhaft und nicht einschränkend. Es können weitere, hier nicht dargestellte Schichten, beispielsweise teilreflektierende oder haftvermittelnde Schichten vorgesehen sein. Ebenfalls nicht dargestellt ist eine in üblicher Weise bei Dünnschicht PV-Modulen vorgesehene und auf der Rückkontaktschicht 15 angeordnete Schutz-und Versiegelungsschicht, beispielsweise aus Polyvinylbutyral (PVB) und eine darauf aufgebrachte, abdeckende weitere Glasscheibe.

Der dargestellte Schnitt verläuft durch einen mittig in der Figur 2 wiedergegebenen Serienverschaltungsstreifen 20, der das PV-Modul in eine erste Photovoltaikzelle 10a auf der linken Seite der Figur 2 und eine zweite Photovoltaikzelle 10b auf der rechten Seite der Figur 2 unterteilt. Der Serienverschaltungsstreifen 20 umfasst mehrere Trennlinien 21 bis 23, von denen eine erste in die frontseitige Elektrodenschicht 12 eingebracht ist, eine zweite in die PV-aktive Schichtanordnung 13 und eine dritte in die rückseitige Elektrodenschicht 14 und die Rückkontaktschicht 15.

Üblicherweise werden die Trennlinien 21 bis 23 während des Beschichtungsprozesses jeweils nach dem Aufbringen bestimmter Schichten des Schichtaufbaus erzeugt. Die Strukturierung eines PV-Moduls über Serienverschaltungsstreifen wird üblicher Weise auch als Patterning bezeichnet, wobei das Einbringen des Strukturierungsmusters der unterschiedlichen Trennlinien Pattern 1, 2, 3 bzw. P1, P2, P3 genannt wird. In Anlehnung an diese Terminologie wird im Folgenden die Trennlinie 21, die in die fronseitige Elektrodenschicht 12 eingebracht ist, auch als P1-Trennlinie 21 bezeichnet, die Trennlinie 22, die in die photovoltaisch aktive Schichtanordnung 13 eingebracht ist, als auch P2-Trennlinie 22 und die Trennlinie 23, die zumindest die rückseitige Elektrodenschicht 14 und die Rückkontaktschicht 15 durchtrennt, auch als P3-Trennlinie 23 bezeichnet. Zur Erzeugung der Trennlinien 21 bis 23 können bekannte Verfahren wie Laserablation (Laser-scribing) oder mechanisches Ritzen eingesetzt werden. Auch ist es möglich die Trennlinien 21 bis 23 bereits bei der Schichtdeposition mithilfe von Masken zu erzeugen. Auch eine Kombination verschiedener Techniken zur Strukturierung ist denkbar.

Durch das Aufbringen der rückseitigen Elektrodenschicht 14 und der Rückkontaktschicht 15 nach dem Einbringen der P2-Trennlinie 22 wird diese mit Material der Elektrodenschicht 14 bzw. der Rückkontaktschicht 15 gefüllt, wodurch ein Kontakt der Elektrodenschicht 14 bzw. Rückkontaktschicht 15 der ersten Photovoltaikzelle 10a mit der frontseitigen Elektrodenschicht 12 der zweiten Photovoltaikzelle 10b erfolgt, der die Serienverschaltung der beiden PV-Zellen 10a, 10b etabliert.

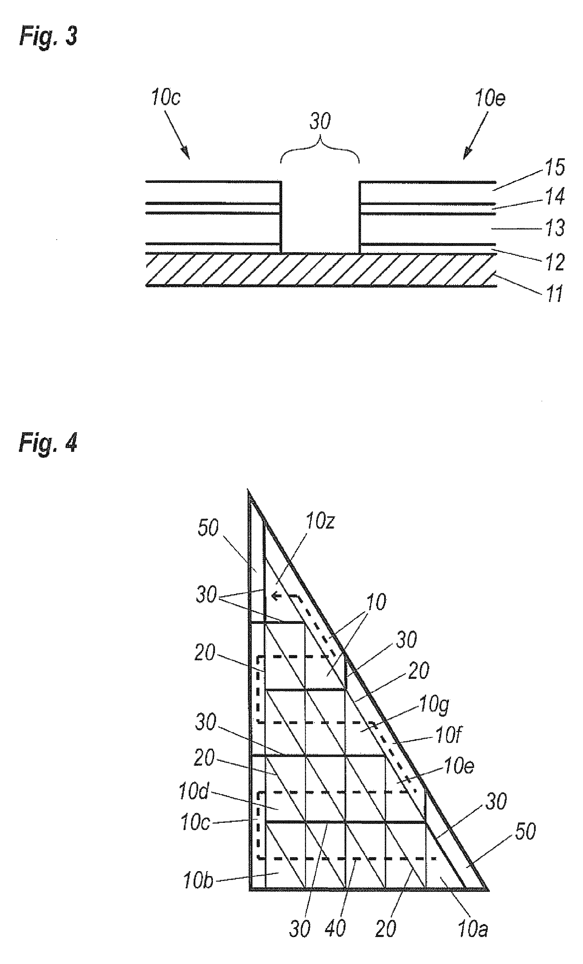

Neben der Schnittlinie II ist in der Figur 1 eine Schnittlinie III im Bereich der Isoliertrennlinie 30 zwischen den Zellen 10c und 10e eingezeichnet. Der Querschnitt entlang dieser Schnittlinie III ist in der Figur 3 dargestellt. In diesem Querschnitt zeigt das PV-Modul zunächst den aus Figur 2 bekannten Schichtaufbau. Im mittleren Bereich der Figur verläuft die Isolier-Trennlinie 30, die alle Schichten des Schichtaufbaus durchtrennt. Sie isoliert folglich die benachbarten PV-Zellen 10c und 10e elektrisch vollständig voneinander.

Mit Bezug auf Figur 1 führt die Ausführung der Isolationstrennlinie 30 in Kombination mit der Anordnung der Serienverschaltungslinien 20, 20a, 20b zu einer Serienverschaltung aller auf den PV-Modul ausgebildeten PV-Zellen 10. Ein Strompfad 40 verläuft dabei von der PV-Zelle 10a über die Serienverschaltungstreifen 20 bis zur PV-Zelle 10c, dann über den Serienverschaltungsstreifen 20a zur PV-Zelle 10d und weiter alternierend über Serienverschaltungstreifen 20b und 20 bis zur PV-Zelle 10z. Zur Illustration der Serienverschaltung ist der Verlauf des Strompfades 40 durch das PV-Modul mithilfe eines gestrichelten Pfeiles wiedergegeben. Die PV-Zellen 10a und 10z stellen Anschlusspunkte des PV-Moduls dar. Die Bezeichnung der beiden PV-Zellen, die die Anschlusspunkte des PV-Moduls darstellen, als PV-Zellen 10a und 10z wird auch in den im Folgenden beschriebenen Ausführungsbeispielen beibehalten.

Ohne die Isolier-Trennlinie 30 wären bei einer Unterteilung des PV-Moduls in wenige Segmente die PV-Zellen 10 an der in der Figur rechten Seitenkante des PV-Moduls zu breit. Dieses würde zu großen ohmschen Verlusten führen. Dagegen wären bei einer Unterteilung des PV-Moduls in viele Segmente diese an dem rechten Winkel des PV-Module (links unten in der Figur) sehr spitz. Dieses würde zu einem großen relativen Anteil der nicht-stromerzeugenden Trennlinien 20 an der Fläche des PV-Moduls führen, was ebenfalls die Effizienz des PV-Moduls verringert. Durch das Vorsehen von Serienverschaltungsstreifen 20, 20a, 20b und der Isolationstrennlinie 30 gelingt ein Kompromiss zwischen den beiden die Effizienz beeinträchtigenden Faktoren. Möglich wird dieses durch die Kombination von einer Isolationstrennlinie 30 und den beiden miteinander serienverschalteten PV-Zellen 10c und 10d, die entlang einer Seitenkante des Dünnschicht-Photovoltaikmoduls angeordnet sind und die zu einem mäanderförmig über das Photovoltaikmodul verlaufenden Strompfad 40 führen..

Geeignete Positionierung der Serienverschaltungsstreifen 20, 20a, 20b und der Isolationstrennlinie 30 erlaubt dabei eine Unterteilung des PV-Moduls in flächengleiche PV-Zellen 10. Bei PV-Modulen mit noch größerer Seitenlänge kann die in der Figur 1 gezeigte Art der Unterteilung des PV-Moduls durch mehrere parallele Isoliertrennlinien erfolgen. Dabei ist es möglich, aber nicht notwendig, dass Serienverschaltungsstreifen über Isoliertrennlinien hinweg fluchtend verlaufen, wie dieses bei dem Serienverschaltungsstreifen 20 der Figur 1 der Fall ist. Es kann eine abschnittsweise fächerförmige Unterteilung auch eines großen PV-Moduls vorgenommen werden, ohne dass einzelne der PV-Zellen 10 in Richtung des Stromflusses eine im Hinblick auf Widerstandsverluste ungünstige Breite aufweisen.

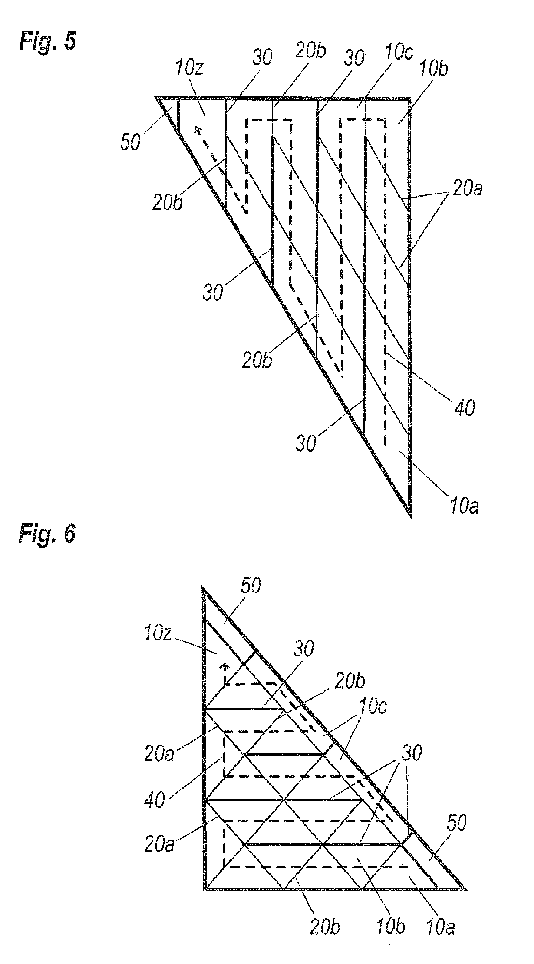

Die Figuren 4-7 zeigen ebenfalls PV-Module mit einer dreieckigen Grundform in einer Aufsicht analog zu dem in der Figur 1 gezeigten Ausführungsbeispiel. Wie in dem Ausführungsbeispiel der Figur 1 sind die PV-Module auch hier jeweils durch eine Kombination von Serienveschaltungsstreifen 20 und Isolier-trennlinien 30 in eine Vielzahl von PV-Zellen 10 unterteilt. Im Unterschied zu den zuvor beschriebenen Ausführungsbeispielen verlaufen die Serienverschaltungsstreifen 20 bei den Ausführungsbeispielen der Figuren 4 und 5 parallel zu den Seiten des jeweiligen PV-Moduls.

Bei dem Ausführungsbeispiel der Figur 4 sind auf diese Weise PV-Zellen gebildet, die die gleiche Grundform wie das PV-Modul aufweisen, deren Seitenlänge jedoch jeweils nur ein Bruchteil der Seitenlänge des PV-Moduls beträgt. Beispiele sind die PV-Zellen 10a und 10c, die wiederum auch die Anschlusspunkte des PV-Moduls darstellen, wie durch den Strompfad 40 angezeigt ist. Die PV-Zellen mit dreieckiger Grundform sind in serienverschalteten Zeilen jeweils abwechselnd um 180° gedreht zueinander angeordnet. Beispielsweise ist eine solche Zeile zwischen den PV-Zellen 10a und 10b oder den PV-Zellen 10d und 10e gebildet. Zwischen benachbarten Zeilen sind Isolier-Trennlinien 30 vorgesehen. Zur Verbindung zweier benachbarter Zeilen sind im Randbereich des PV-Moduls PV-Zellen 10c mit rechteckiger Grundform und PV-Zellen 10f mit einem Parallelogramm als Grundform ausgebildet. Ein sich ergebender Strompfad 40 ist wiederum als gestrichelter Pfeil von der PV-Zelle 10a bis zur PV-Zelle 10z eingezeichnet und verläuft mäanderförmig über das PV-Modul.

An die PV-Zellen 10a und 10z grenzen viereckige Bereiche 50 an. Diese sind von allen jeweilig benachbarten PV-Zellen 10 durch Isolier-Trennlinien 30 abgetrennt. Sie tragen im gezeigten Beispiel nicht zur Stromerzeugung bei. Es ist jedoch auch denkbar, diese Bereiche 50 den PV-Zellen 10a und 10z zuzuschlagen.

Bei dem Ausführungsbeispiel der Figur 5 sind einerseits PV-Zellen 10 gebildet, die Parallelogramm als Grundform aufweisen (z.B. die PV-Zellen 10a, 10b) und andererseits solche, deren Grundform die eines ungleichmäßigen Trapezes ist (PV-Zellen 10c, 10z). In einer Richtung parallel zu der dem rechten Winkel gegenüberliegenden Seite des PV-Moduls verlaufen Serienverschaltungsstreifen 20a. In einer Richtung parallel zu der im Bild vertikalen Seite des PV-Moduls verlaufen Isolier-Trennlinien 30, die das PV-Modul jedoch nicht in seiner gesamten Ausdehnung unterteilen. Alternierend oben und unten sind die Isolier-Trennlinien 30 durch Serienverschaltungsstreifen 20b vorlängert. Es ergibt sich ein Strompfad 40, der ausgehend von der PV-Zelle 10a entlang einer Spalte über die Serienverschaltungsstreifen 20a zur PV-Zelle 10b führt, dann über einen der Serienverschaltungsstreifen 20b zur PV-Zelle 10c der nächsten Spalte, die bis zur PV-Zelle 10d reicht. In Spalten abnehmender Länge erreicht der Strompfad 40 auf diese Weise die PV-Zelle 10z.

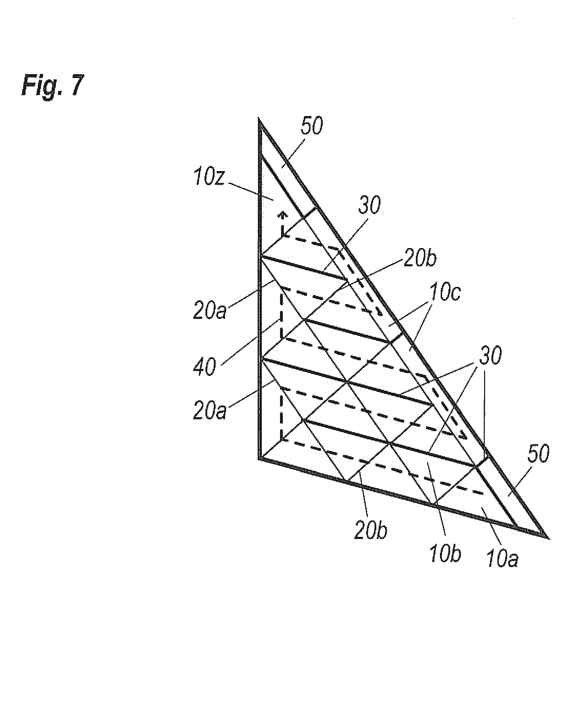

Bei den Ausführungsbeispielen der Figuren 6 und 7 erfolgt eine Unterteilung des PV-Moduls in PV-Zellen 10 durch Serienverschaltungsstreifen 20a, die parallel zu einer Seite des PV-Moduls verlaufen und Serienverschaltungsstreifen 20b, die parallel zu einer Winkelhalbierenden der dieser Seite gegenüberliegenden Ecke des PV-Moduls verlaufen. Auf diese Weise wird eine Kachelung eines Bereichs des PV-Moduls durch eine Vielzahl von jeweils formgleichen, jedoch unterschiedlich ausgerichteten PV-Zellen 10 (10a, 10b, 10z) erreicht. Darüber hinaus sind entlang der genannten Seite viereckige PV-Zellen 10c ausgebildet. Wiederum sind zudem Isolier-Trennlinien 30 eingebracht, die in Kombination mit den Serienverschaltungsstreifen 20a, 20b in einer Serienverschaltung der PV-Zellen 10 entlang des eingezeichneten, mäanderförmig über das PV-Modul verlaufenden Strompfades 40 von der PV-Zelle 10a bis zur PV-Zelle 10z resultiert. Benachbart zu den PV-Zellen 10a und 10z befinden sich wiederum nicht verschaltete Bereiche 50, die jedoch ebenfalls wiederum den PV-Zellen 10a und 10z als aktive Zellfläche zugeschlagen werden können.

Die Grundform des PV-Moduls ist beim Ausführungsbeispiel der Figur 6 dabei wie in den zuvor gezeigten Ausführungsbeispielen die eines rochtwinkligen Dreiecks. Figur 7 zeigt dagegen ein Ausführungsbeispiel mit einer schiefwinklig dreieckigen Grundform. Es sei angemerkt, dass auch die in den Ausführungsbeispielen der Figuren 1, 4 und 5 dargestellte Verschaltungsart nicht auf PV-Module mit einer rechtwinklig-dreieckigen Grundform beschränkt ist.

In nicht dargestellten alternativen Ausgestaltung kann zudem durch eine entsprechende Anordnung von Serienverschaltungsstreifen und Isolier-Trennstreifen vorgesehen sein, dass jeweils mehrere PV-Zellen zu je einem Strang integriert serienverschaltet sind und mehrere solcher Stränge parallel verschaltet sind. Beispielsweise können zwei PV-Zellen, die dem Anschluss des PV-Moduls dienen, über zwei oder mehr ansonsten voneinander isolierte Stränge miteinander verbunden sein. Die zwei oder mehr Stränge weisen jeweils die gleiche Anzahl an PV-Zellen mit jeweils gleicher Fläche auf. Die Fläche der zwei PV-Zellen, die dem Anschluss des PV-Moduls dienen, beträgt jeweils ein Mehrfaches der Fläche einer PV-Zelle im Strang, wobei der Faktor der Flächen genau der Anzahl der Stränge entspricht. Auch in der Ausführung mit mehreren Strängen sind alle PV-Zellen integriert miteinander verschaltet.

**Bezugszeichen**
- 10: Photovoltaikzelle
- 11: Substrat
- 12: frontseitige Elektrodenschicht
- 13: photovoltaisch aktive Schichtenanordnung
- 14: rückseitige Elektrodenschicht
- 15: Rückkontaktschicht
- 20: Serienverschaltungsstreifen
- 21: P1-Trennlinie
- 22: P2-Trennlinie
- 23: P3-Trennlinie
- 30: Isolier-Trennlinie
- 40: Strompfad
- 50: nicht verschalteter Bereich

## Patentansprüche

1. Dünnschicht-Photovoltaikmodul, das durch Trennlinien (21-23, 30), die mindestens eine Schicht eines Schichtaufbaus des Dünnschicht-Photovoltaikmoduls durchtrennen, in eine Vielzahl von auf einem Substrat (11) angeordneten und integriert elektrisch serienverschalteten Photovoltaikzellen (10) unterteilt ist, wobei
- zumindest zwei der Trennlinien (21-23, 30) nicht parallel zueinander verlaufen,
- zumindest ein Teil der Trennlinien (21-23) Teil eines Serienverschaltungsstreifens (20) ist, der zwei angrenzende Photovoltaikzellen (10) serienverschaltet, und
- mindestens eine der Trennlinien (30) alle Schichten des Dünnschicht-Photovoltaikmoduls durchtrennt und zwei angrenzende Photovoltaikzellen (10) gegeneinander elektrisch isoliert,
**dadurch gekennzeichnet, dass**
Serienverschaltungsstreifen (20) und isolierende Trennlinien (30) so angeordnet sind, dass ein Strompfad (40) gebildet wird, der mäanderförmig über das Dünnschicht-Photovoltaikmodul verläuft.

2. Dünnschicht-Photovoltaikmodul nach Anspruch 1, das von den Trennlinien (21-23, 30) in flächengleiche Photovoltaikzellen (10) unterteilt ist.

3. Dünnschicht-Photovoltaikmodul nach Anspruch 1 oder 2, bei dem zumindest ein Teil der Photovoltaikzellen (10) eine dreieckige, trapezförmige oder hexagonale Grundform aufweist.

4. Dünnschicht-Photovoltaikmodul nach einem der Ansprüche 1 bis 3, bei dem zumindest ein Teil der Photovoltaikzellen (10) die gleiche geometrische Grundform hat wie das Dünnschicht-Photovoltaikmodul.

5. Dünnschicht-Photovoltaikmodul nach einem der Ansprüche 1 bis 4, bei dem alle Photovoltaikzellen (10) eine gleiche geometrische Grundform aufweisen.

6. Dünnschicht-Photovoltaikmodul nach einem der Ansprüche 1 bis 5, bei dem solche Photovoltaikzellen (10), die an mehr als zwei benachbarte Photovoltaikzellen (10) angrenzen, mit zweien der angrenzenden Photovoltaikzellen (10) serienverschaltet sind, wohingegen sie gegenüber allen weiteren angrenzenden Photovoltaikzellen (10) elektrisch isoliert sind.

7. Dünnschicht-Photovoltaikmodul nach einem der Ansprüche 1 bis 6, bei dem der Strompfad (40) von einer ersten Photovoltaikzelle (10a) bis zu einer letzten Photovoltaikzelle (10z) gebildet ist und dabei alle Photovoltaikzellen (10) des Dünnschicht-Photovoltaikmoduls umfasst.

8. Dünnschicht-Photovoltaikmodul nach einem der Ansprüche 1 bis 7, bei dem ein Stromfluss zwischen zwei ersten benachbarten Photovoltaikzellen (10) eine andere Richtung aufweist als ein Stromfluss zwischen zwei zweiten benachbarten Photovoltaikzellen (10).
